(19) Europäisches Patentamt
European Patent Office
Office européen des brevets

(11) **EP 3 041 086 B1**

(12) **EUROPEAN PATENT SPECIFICATION**

(45) Date of publication and mention
of the grant of the patent:
**04.12.2019 Bulletin 2019/49**

(51) Int Cl.:
*H01Q 1/36* (2006.01)  *H01Q 1/27* (2006.01)
*H01Q 1/44* (2006.01)  *H01Q 9/04* (2006.01)
*H01Q 1/38* (2006.01)

(21) Application number: **15191871.1**

(22) Date of filing: **28.10.2015**

(54) **ANTENNA DEVICE AND ELECTRONIC DEVICE INCLUDING THE SAME**

ANTENNENVORRICHTUNG UND ELEKTRONISCHE VORRICHTUNG DAMIT

DISPOSITIF D'ANTENNE ET DISPOSITIF ÉLECTRONIQUE COMPRENANT CELUI-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.12.2014 KR 20140192252**

(43) Date of publication of application:
**06.07.2016 Bulletin 2016/27**

(73) Proprietor: **Samsung Electronics Co., Ltd.
Gyeonggi-do 16677 (KR)**

(72) Inventors:
• **Hong, Won-Bin**
**16677 Suwon-si, Gyeonggi-do (KR)**
• **Ko, Seung-Tae**
**16677 Suwon-si, Gyeonggi-do (KR)**
• **Kim, Yoon-Geon**
**16677 Suwon-si, Gyeonggi-do (KR)**
• **Lim, Sang-Ho**
**16677 Suwon-si, Gyeonggi-do (KR)**

(74) Representative: **Gulde & Partner
Patent- und Rechtsanwaltskanzlei mbB
Wallstraße 58/59
10179 Berlin (DE)**

(56) References cited:
**EP-A1- 1 868 263    EP-A1- 2 416 443
EP-A2- 0 911 906    US-A1- 2014 045 424**

## Description

### BACKGROUND

Various embodiments of the present disclosure relate to an electronic device, for example, an antenna device allowing wireless communication and an electronic device including the same.

Wireless communication techniques have been implemented in a variety of ways including commercialized mobile communication network connection, and recently, a wireless Local Area Network (w-LAN) represented by Wireless-Fidelity (Wi-Fi), Bluetooth, Near Field Communication (NFC), and so forth. A mobile communication service, evolving from the 1st-Generation (1G) mobile communication service focusing on voice communication to the 4th-Generation (4G) mobile communication network, is now providing Internet and multimedia services. Such wireless communication is provided in various frequency bands of 700 MHz, 1.8 GHz, 2.1 GHz, 2.4 GHz, 5 GHz, 2.45 GHz, and so forth according to communication schemes, and a next-generation mobile communication service to be used later is expected to be provided in ultra-high frequency bands over several tens of GHz.

As communication standards, such as short-range wireless communication or Bluetooth, have come into common use, electronic devices, for example, mobile communication terminals have mounted antenna devices corresponding to frequency bands and communication schemes for wireless communication in different various frequency bands. The antenna device is installed sufficiently spaced apart from other circuit devices to suppress interference with the other circuit devices and to guarantee stable performance during transmission and reception of a high-frequency signal.

Some electronic devices need to be size-reduced and light-weighted to secure portability. For example, for mobile communication terminals having been already commercialized or body-wearable electronic devices such as a wrist-watch type or glass-type electronic device, miniaturization and lightweight are required for convenience of users.

However, in a miniaturized and light-weighted electronic device, it is difficult to secure an installation space for an antenna device.

The above information is presented as background information only to assist with an understanding of the present disclosure. No determination has been made, and no assertion is made, as to whether any of the above might be applicable as prior art with regard to the present disclosure.

EP 0 911 906 A2 discloses a transparent planar antenna for use over the LCD of a wireless communications unit, the transparent planar antenna being fabricated from a thin film of metal mounted on a transparent insulator.

EP 1 868 263 A1 is directed to a transparent antenna for a display, for example, a portable telephone, the transparent antenna performing good transmission and reception, not bulky, and not impairing design of an apparatus.

### SUMMARY

Aspects of the present disclosure have been made to at least partially solve, alleviate, or remove at least one of problems and/or disadvantages described above.

Accordingly, various aspects of the present disclosure provide an antenna device which is easy to install in a small space and an electronic device including the same.

Accordingly, various aspects of the present disclosure provide an antenna device which may be installed in a screen display region of a display device while maintaining visibility of the display device and an electronic device including the antenna device.

Other objects to be provided in the present disclosure may be understood by embodiments described below.

According to an aspect of the present disclosure, there is provided an electronic device including a dielectric substrate having a plurality of surfaces, a mesh grid including conducting wires formed on, preferably directly on at least one of the plurality of surfaces of the dielectric substrate, a first portion of the mesh grid having a radiation conductor formed by a first plurality of the conducting wires, and a second portion of the mesh grid having a dummy pattern formed by a second plurality of conducting wires, wherein the second conducting wires comprise at least one discontinuous portions that are opened such that the dummy pattern electrically opens the first portion which forms the radiation conductor from the mesh grid less the first portion, e.g. from the remaining mesh grid. The line width of the second conducting wires is larger than the line width of the first conducting wires such that a light transmittance of the first portion and a light transmittance of the second portion is substantially uniform.

According to another aspect of the present disclosure, there is provided an antenna device including a dielectric substrate formed of a transparent material, a mesh grid comprising transparent conducting wires formed on, preferably directly on at least one surface of the dielectric substrate, a first portion of the mesh grid having a radiation conductor formed by a first plurality of the conducting wires, and a second portion of the mesh grid having a dummy pattern formed by a second plurality of conducting wires, in which the dummy pattern comprises at least one discontinuous portion in which portions of the second conducting wires are opened, to electrically open the first portion forming the radiation conductor from the mesh grid less the first portion or in other words from the remaining mesh grid, and the first conducting wires are formed to have a line width that is different from a line width of the second conducting wires.

Other aspects, advantages, and salient features of the disclosure will become apparent to those skilled in the art from the following detailed description, which, taken in conjunction with the annexed drawings, discloses various embodiments of the present disclosure.

Before undertaking the detailed description below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely. Definitions for certain words and phrases are provided throughout this patent document, those of ordinary skill in the art should understand that in many, if not most instances, such definitions apply to prior, as well as future uses of such defined words and phrases.

BRIEF DESCRIPTION OF THE DRAWINGS

The above and other aspects, features and advantages of embodiments of the present disclosure will be more apparent from the following description taken in conjunction with the accompanying drawings, in which:

FIG. 1 is an exploded perspective view showing an electronic device according to various embodiments of the present disclosure;

FIG. 2 is a plane view showing an antenna device according to various embodiments of the present disclosure;

FIG. 3 is a plane view showing a modified example of an antenna device according to various embodiments of the present disclosure;

FIG. 4 is an enlarged view of a portion of a mesh grid of an antenna device according to various embodiments of the present disclosure;

FIG. 5 is an enlarged view of another portion of a mesh grid of an antenna device according to various embodiments of the present disclosure;

FIG. 6 is a cross-sectional view of a portion of an electronic device according to various embodiments of the present disclosure; and

FIG. 7 is a cross-sectional view of another example of an antenna device according to various embodiments of the present disclosure.

Throughout the drawings, like reference numerals will be understood to refer to like parts, components, and structures.

DETAILED DESCRIPTION

Various changes may be made to the present disclosure and the present disclosure may have various embodiments which will be described in detail with reference to the drawings. However, the embodiments according to the concept of the present disclosure are not construed as limited to specified disclosures, and include all changes, equivalents, or substitutes that do not depart from the scope of the present disclosure.

While terms including ordinal numbers, such as "first" and "second", or the like, may be used to describe various components, such components are not limited to the above terms. The above terms are used only to distinguish one component from another. For example, a first component may be referred to as a second component without departing from the scope of rights of the present disclosure, and likewise a second component may be referred to as a first component. The term "and/or" includes a combination of a plurality of related provided items or any one of the plurality of related provided items.

Relative terms used based on illustration in the drawings, such as a "front surface", a "rear surface ", a "top surface", a "bottom surface", and the like, may be replaced with ordinal numbers such as "first", "second", and the like.

The order of the ordinal numbers such as "first", "second", and the like is a mentioned order or an arbitrarily set order, and may be changed as needed.

The terminology used herein is for the purpose of describing an embodiment only and is not intended to be limiting of an embodiment. As used herein, the singular forms are intended to include the plural forms as well, unless the context clearly indicates otherwise. It will be further understood that the terms "comprises" and/or "has" when used in this specification, specify the presence of a stated feature, number, step, operation, component, element, or a combination thereof but do not preclude the presence or addition of one or more other features, numbers, steps, operations, components, elements, or combinations thereof.

Unless defined otherwise, all terms used herein have the same meanings as generally understood by those having ordinary knowledge in the technical field to which the present disclosure pertains. Terms generally used and defined in dictionaries should be interpreted as having meanings consistent with meanings construed in the context of the related art, and should not be interpreted as having ideal or excessively formal meanings unless defined explicitly in the present disclosure.

In various embodiments of the present disclosure, an electronic device may be an arbitrary device having a touch panel and may be referred to as a terminal, a portable terminal, a mobile terminal, a communication terminal, a portable communication terminal, a portable mobile terminal, a display, or the like.

For example, the electronic device may be a smart phone, a cellular phone, a navigation device, a game console, a TeleVision (TV), a vehicle head unit, a laptop computer, a tablet computer, a Personal Multimedia Player (PMP), a Personal Digital Assistant (PDA), or the like. The electronic device may be implemented with a pocket-size portable communication terminal having a wireless communication function. The electronic device may be a flexible device or a flexible display.

The electronic device may communicate with an external electronic device such as a server or may work by cooperating with the external electronic device. For example, the electronic device may transmit an image captured by a camera and/or position information detected by a sensor unit to the server over a network. The network may be, but not limited to, a mobile or cellular communication network, a Local Area Network (LAN), a Wireless Local Area Network (WLAN), a Wide Area Network (WAN), Internet, or a Small Area Network (SAN).

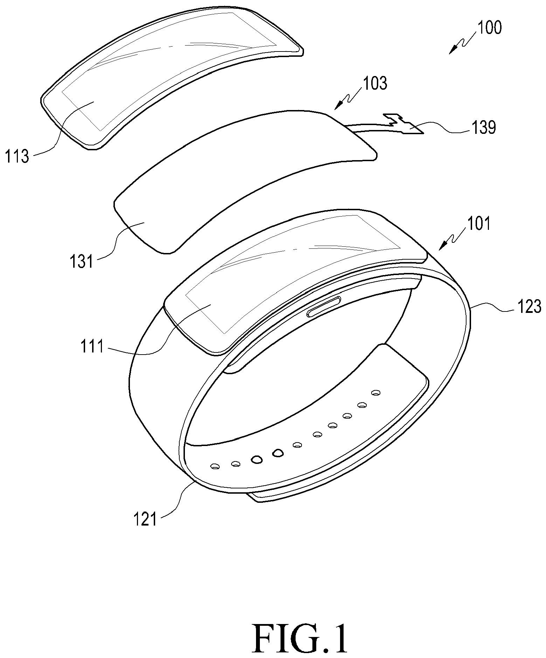

FIG. 1 is an exploded perspective view showing an electronic device 100 according to various embodiments of the present disclosure.

Referring to FIG. 1, the electronic device 100 may include wearing members 121 and 123 extending from either sides (or ends) of a main body portion 101, respectively. The wearing members 121 and 123 are bound to each other, while partially overlapping each other, to allow the electronic device 100 to be worn on a user's body (e.g., a wrist). The main body portion 101 may have embedded therein various circuit devices such as a processor (e.g., an Application Processor (AP)), a communication module, a memory, a battery, and so forth, and may include a display device 111 mounted on a surface thereof. The display device 111 may include a Liquid Crystal Display (LCD), a Light-Emitting Diode (LED) display, an Organic Light-Emitting Diode (OLED) display, a MicroElectroMechanical Systems (MEMS) display, an electronic paper display, and the like. The display device 111 displays or outputs various contents (e.g., pictures, moving images, and so forth), and displays or outputs execution screens of various applications (e.g., games, Internet banking, schedule management, and so forth) according to user's manipulation.

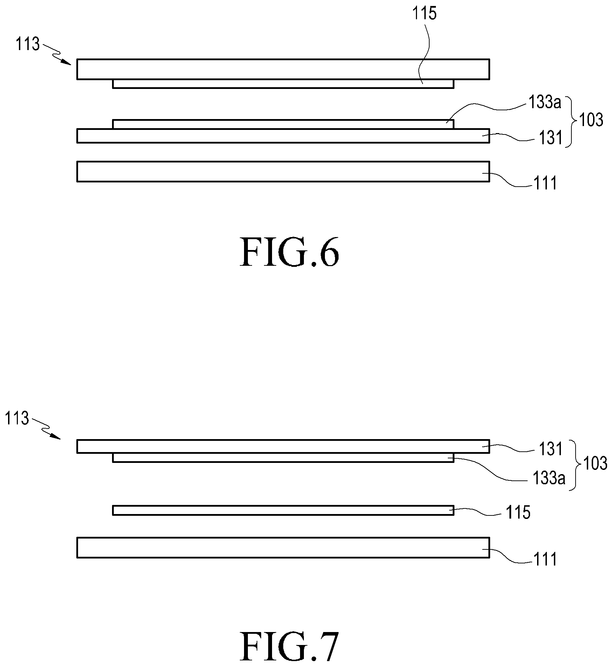

A window member 113 is mounted on a front or outer surface of the main body portion 101 to protect the display device 111. The window member 113 is manufactured with a transparent material, for example, glass or synthetic resin (e.g., acryl, polycarbonate, or the like) to pass the screen output from the display device 111 therethrough and to protect the display device 111 from an external environment. If the electronic device 100 has a touch screen function, a touch screen panel may be installed on the display device 111. The touch screen panel may be integrated into the display device 111 or the window member 113, and this structure will be described in more detail with reference to FIG. 6 or 7.

The electronic device 100 may include an antenna device 103 which may be manufactured in the form of a film and installed in a proper position on the main body portion 101. For example, the antenna device 103 may be attached to any one of an outer surface of the display device 111, an inner surface of the window member 113, an outer surface of the window member 113, and an inner surface (confronting the wearing members 121 and 123) of the main body portion 101. In a detailed embodiment of the present disclosure, the antenna device 103 is installed on a front or outer surface of the main body portion 101.

The antenna device 103 may connect to a circuit device (e.g., a communication module) embedded in the main body portion 101 using the transmission line 139 included therein. The transmission line 139 may be implemented with a Flexible Printed Circuit Board (FPCB) and according to an embodiment, may be implemented with a coaxial cable or the like. The transmission line 139 connects the antenna device 103 to the circuit device of the electronic device 100 to feed electricity to the antenna device 103. When the antenna device 103 is installed on the display device 111, the antenna device 103 may secure a light transmittance to allow the screen output by the display device 111 to pass therethrough. As mentioned previously, the antenna device 103 may be installed inside the main body portion 101, and in this case, it may be optional to consider whether displays of the display device 111 may pass through the antenna device 103, improving the degree of freedom of designing.

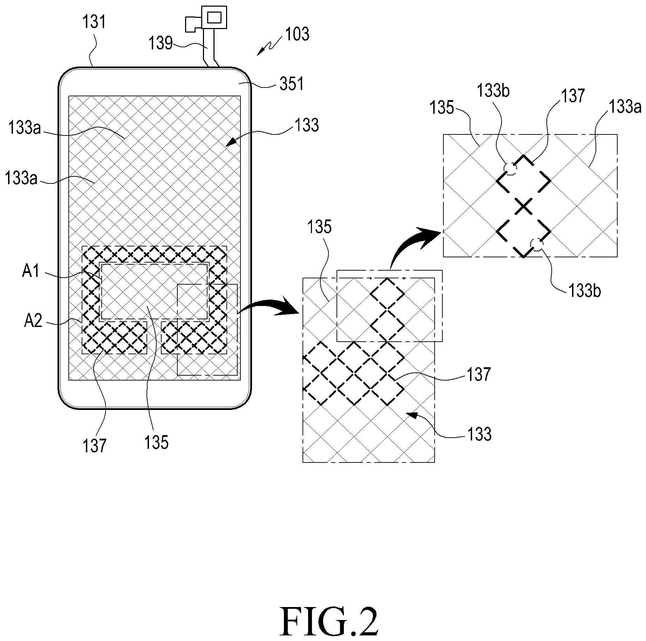

Hereinbelow, with reference to FIGS. 2 through 5, a detailed structure of the antenna device 103 will be described.

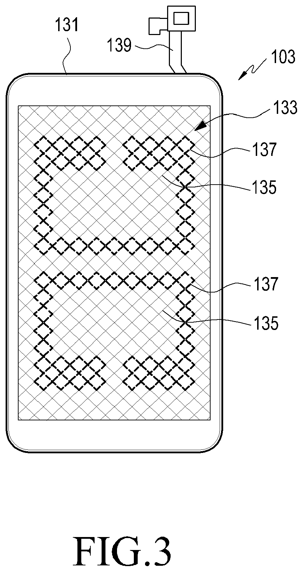

FIG. 2 is a plane view showing the antenna device 103 according to various embodiments of the present disclosure. FIG. 3 is a plane view showing a modified example of the antenna device 103 according to various embodiments of the present disclosure.

Referring to FIGS. 2 and 3, the antenna device 103 may include a mesh grid 133 formed on, preferably directly on a dielectric substrate 131 and a portion of the mesh grid 133 may be used as a radiation conductor 135. For convenience, the dielectric substrate 131 and the mesh grid 133 (e.g., conducting wires 133a of the mesh grid 133) are illustrated in FIGS. 2 and 3, but the antenna device 103 may be positioned on the display device 111 as mentioned above, such that the dielectric substrate 131, the mesh grid 133, and the conducting wires 133a may be manufactured with a transparent material.

The dielectric substrate 131 may include a film manufactured with a transparent (e.g., a high-light-transmittance) material, for example, high-polymer synthetic resin such as polyimide or the like, but the present disclosure is not limited thereto. For example, the window member 113 may be used as a substrate of the antenna device 103 as will be described with reference to FIG. 7. The dielectric substrate 131 may be manufactured with a flexible material. For example, if the dielectric substrate 131 includes a film manufactured with high-polymer synthetic resin such as polyimide, it may be easily attached to a surface (e.g., an inner surface or outer surface) of the window member 113 having a curved-surface form.

The mesh grid 133 is formed with an arrangement of the conducting wires 133a in a grid. In some embodiments, the conducting wires 133a are transparent conductors. The transparent conductor for forming the conducting wires 133a may include graphene, nanowire, Indium-Tin Oxide (ITO), Indium-Zinc Oxide (IZO), Aluminum-Zinc Oxide (AZO), Ga-doped Zinc Oxide (GZO), Zinc-Tin Oxide (ZTO), Aluminum-Zinc-Tin Oxide (AZTO), Indium-Aluminum-Zinc-Tin Oxide (IAZTO), Indium-Zinc-Tin Oxide (IZTO), and so forth. The transparent conductors may have a light transmittance of a predetermined level, and the conducting wires 133a may be formed to a line width of several micrometers on one or more surfaces of the dielectric substrate 131 through a printing or deposition process.

When the mesh grid 133 is formed, a portion (hereinafter, a 'first portion A1') is electrically opened from another portion of the mesh grid 133. In this way, the first portion may be used as the radiation conductor 135. Electrical opening may be implemented by removing at least a portion of one or more of the transparent conductors of the conducting wires 133a from further another portion (hereinafter, a 'second portion A2') of the mesh grid 133 on or near a circumference or a perimeter of the first portion A1. Generally, even if conductor wires for forming the mesh grid 133 (e.g., the conducting wires 133a) are formed of a transparent material, light transmittance of the conductor wires may not be 100%. Thus, if all the conducting wires 133a are removed from the second portion A2 for electrical opening from the first portion A1 of the mesh grid 133, a deviation in light transmittance may occur between the second portion A2 and the first portion A1. In the antenna device 103 according to various embodiments of the present disclosure, all the conducting wires may not be removed from the second portion A2, and at least one open portion (hereinafter, a 'discontinuous portion 133b') may be formed in some of the conducting wires 133a to secure a substantially uniform light transmittance over the dielectric substrate 131. For example, by forming discontinuous portion(s) 133b in the second portion A2, the light transmittance deviation between the first portion A1 and the second portion A2 may be reduced or suppressed while providing an electrical open structure. As such, in the mesh grid 133, a dummy pattern 137 including the discontinuous portion(s) 133b is formed in the second portion A2, thereby reducing or suppressing a deviation in light transmittance and electrically opening the first portion A1, for example, the radiation conductor 135, from another portion of the mesh grid 133. According to the invention, the light transmittance deviation between the first portion A1 and the second portion A2 may be less than 2%, preferably less than 1%.

The first portion A1 has a grid form in which a conductor portion (where the conducting wires are formed) and a dielectric portion (where the conducting wires are not formed) are separated. However, the conducting wires 133a forming the mesh grid 133 are arranged at dense intervals (e.g., at intervals of several tens of micrometers or less), such that the first portion A1 may be used as a flat-plate conductor for an Alternating Current (AC). For example, the mesh grid 133 formed in the first portion A1 may form a radiation conductor having a flat-plate patch antenna structure. As mentioned previously, the conducting wires positioned in the second portion A2 form the dummy pattern 137 including the discontinuous portion(s) 133b, such that the radiation conductor 135 may be electrically opened from a remaining portion of the mesh grid 133.

As shown in FIGS. 2 and 3, the radiation conductor 135 may be implemented as a single radiation conductor or as a plurality of radiation conductors 135 on the dielectric substrate 131. For example, the number of radiation conductors 135 formed on the dielectric substrate 131 may vary according to a wireless communication frequency band required in the electronic device 100.

For brevity of a detailed description and the drawings, the radiation conductor 135 is illustrated in a shape forming a flat-plate conductor (e.g., a patch antenna structure), but the radiation conductor 135 may have a structure of, or may form a part of any one of a slot antenna, a loop antenna, a mono-pole antenna, a dipole antenna, and a Yagi-Uda antenna, according to arrangement of the second portion A2, for example, the dummy pattern 137. According to various embodiments, a plurality of radiation conductors having the same antenna structure may be formed on one dielectric substrate. According to various embodiments, a plurality of radiation conductors having different antenna structures (e.g., a combination of structures selected from among the above-listed antenna structures) may be formed on a single dielectric substrate.

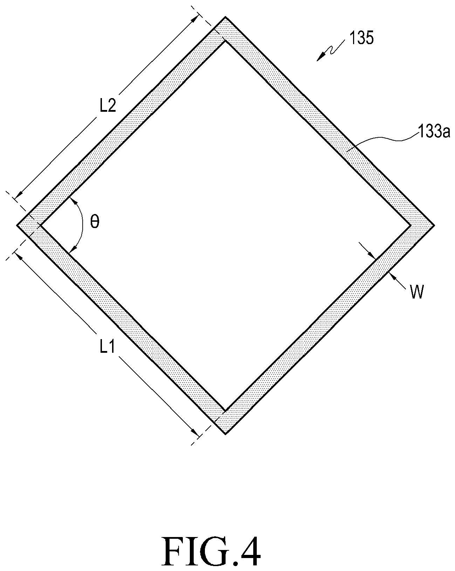

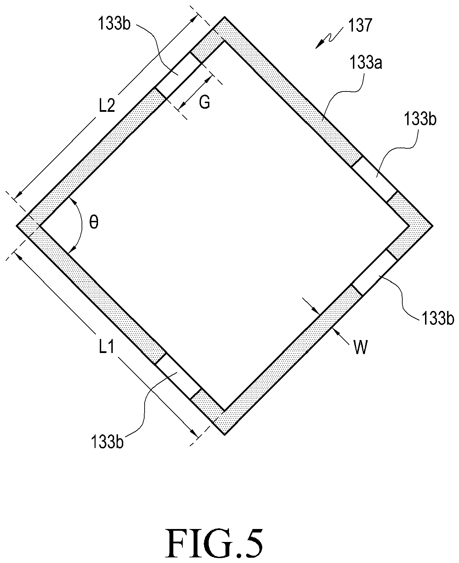

FIG. 4 is an enlarged view of a portion of the mesh grid 133 of the antenna device 103 according to various embodiments of the present disclosure. FIG. 5 is an enlarged view of another portion of the mesh grid 133 of the antenna device 103 according to various embodiments of the present disclosure.

FIGS. 4 and 5 illustrate arrangement of the conducting wires 133a forming the radiation conductor 135 and arrangement of the conducting wires 133a forming the dummy pattern 137, respectively. Hereinbelow, referring to FIGS. 4 and 5, a structure for securing a substantially uniform light transmittance over the antenna device 103, for example, the dielectric substrate 131 will be described. In FIGS. 4 and 5, as examples, the conducting wires 133a as a part of the radiation conductor 135 and the conducting wires 133a as a part of the dummy pattern 137 are arranged in the form of a quadrangle. Also, Equation (1) defines an opened area rate based on arrangement of the conducting wires 133a illustrated in FIGS. 4 an 5. However, the structure shown in FIGS. 4 and 5 and Equation (1) provided below have been simplified to facilitate understanding of various embodiments of the present disclosure, and the present disclosure is not limited thereto. The opened area rate as defined in Equation (1) may vary with arrangement of the conducting wires 133a. For example, the conducting wires 133a are illustrated in the shape of a quadrangle in FIGS. 4 and 5, but Equation (1) may be adjusted to calculate an opened area rate of the structure in which the conducting wires 133a are arranged in the form of a window or in the form of a grid as shown in FIG. 2. Although the dummy patterns 137 may not form a complete quadrangle due to the discontinuous portion 133b, they will be regarded as a quadrangle for brevity of the description.

When the mesh grid 133 is formed, a line width of the conducting wires 133a forming the radiation conductor 135 and a line width of the conducting wires 133a forming the dummy pattern 137 may be adjusted to secure a substantially uniform light transmittance over the dielectric substrate 131. If the line width of the conducting wires 133a forming the dummy pattern 137 and the line width of the conducting wires 133a forming the radiation conductor 135 are substantially identical or uniform, an opened area rate of the second portion A2 where the discontinuous portions 133b are positioned may be higher than that of the first portion A1. Thus, by making the line width of the conducting wires 133a forming the dummy pattern 137 different from the line width of the conducting wires 133a forming the radiation conductor 135, for example, by making the line width of the conducting wires 133a forming the dummy pattern 137 larger than the line width of the conducting wires 133a forming the radiation conductor 135, the opened area rate of the dummy pattern 137 may be set to be similar or equal to that of the radiation conductor 135. By setting the opened area rate of the radiation conductor 135 and the opened area rate of the dummy pattern 137 to be similar or equal to each other, a light transmittance of the first portion A1 corresponding to the radiation conductor 135 and a light transmittance of the second portion A2 corresponding to the dummy pattern 137 may be set to be substantially uniform.

Herein, an 'opened area rate' is thus defined as a rate of a region where the conducting wires 133a are not formed with respect to a total area of a quadrilateral region where a radiation conductor 135 or a dummy pattern 137 is formed, and may be defined as:

$$\text{Opened Area Rate} = \frac{(L1+2W)(L2+2W)\sin\theta - 2W(L1+L2+2W) + GWN}{(L1+2W)(L2+2W)\sin\theta} \cdots\cdots (1),$$

where L1 and L2 represent lengths of sides of a quadrangle formed by the conducting wires 133a, W represents a line width of the conducting wires 133a, θ represents an angle between two adjacent conducting wires 133a, G represents a length of the discontinuous portion(s) 133b, and N represents the number of discontinuous portion(s) 133b. In Equation (1), the term '(L1+2W)(L2+2W)sinθ' may indicate a total area of a quadrilateral region where a radiation conductor 135 or a dummy pattern 137 is formed, the term '2W(L1+L2+2W)' may indicate a surface area of the conducting wires 133a, and 'GWN' may indicate an area of the discontinuous portion(s) 133b on a locus where the conducting wires 133a are formed. When the antenna device 103 according to various embodiments of the present disclosure is configured, the length or line width of the conducting wires 133a may be formed in 'micrometer' units or 'μm', and the units may not be described below.

The radiation conductor 135 illustrated in FIG. 4 is in a closed-loop shape where the discontinuous portion 133b is not formed, such that 'GWN' may be equal to 0. To form the radiation conductor 135, if the lengths L1 and L2 of the conducting wires 133a are set to 120 μm, the line width W of the conducting wires 133a is set to 4 μm, and an inclination θ between the conducting wires 133a is set to 90°, then an opened area rate of the radiation conductor 135 is calculated as 87.5%.

To form the dummy pattern 137 illustrated in FIG. 5, if the lengths L1 and L2 of the conducting wires 133a are

set to 120 μm, the line width W of the conducting wires 133a is set to 4 μm, the inclination θ between the conducting wires 133a is set to 90°, and four discontinuous portion(s) 133b, each having a length G of 30 μm, are formed, then an opened area rate of the dummy pattern 137 is calculated as 90.6%.

As such, if the radiation conductor 135 and the dummy pattern 137 are formed with conducting wires having the same size and same line width, the dummy pattern 137 including the discontinuous portion(s) 133b may have a higher opened area rate than the radiation conductor 135 and a light transmittance may be higher in the second portion A2 where the dummy pattern 137 is formed than in the first portion A1. Such a deviation in light transmittance may cause a Moire phenomenon in which an interference fringe is generated by an overlap between two or more periodic wave patterns. If the antenna device 103 is disposed on the display device 111, display quality may be degraded.

According to Equation (1), under the condition that the lengths L1 and L2 of the conducting wires 133a are maintained constant, the line width W of the conducting wires 133a and the length G and number N of discontinuous portion(s) 133b may be adjusted to adjust the opened area rate of the dummy pattern 137. For example, by setting the length G of the discontinuous portion(s) 133b to 10 μm while maintaining the lengths L1 and L2 or line width W of the conducting wires 133a to be identical to those in the above condition, the opened area rate of the dummy pattern 137 may be adjusted to 88.5%.

To form the dummy pattern 137, if the above condition is maintained by setting the lengths L1 and L2 of the conducting wires 133a to 120 μm, the inclination θ between the conducting wires 133a to 90°, and forming four discontinuous portion(s) 133b, each having a length G of 30 μm, and the line width W of the conducting wires 133a is adjusted to 5.33 μm, then the opened area rate of the dummy pattern 137 may be 87.5% which is equal to the aforementioned opened area rate of the radiation conductor 135. For example, by adjusting the line width W of the conducting wires 133a of the dummy pattern 137, light transmittances of the first portion A1 and the second portion A2 may be set to be substantially uniform.

In the above-described structure of the dummy pattern 137, the line width W of the conducting wires 133a of the dummy pattern 137 may be proportional to the length G and number N of discontinuous portion(s) 133b, as can be seen from Table 1 showing a relationship between the line width W of the conducting wires 133a and the number N of discontinuous portion(s) 133b to result in an opened area rate of 87.5% when the lengths L1 and L2 of the conducting wires 133a are set to 120 μm and the length G of the discontinuous portion(s) 133b is set to 30 μm.

[Table 1]

| Number (N) of Discontinuous Portion(s) | | Line Width (W) of Conducting Wires (μm) | Opened Area Rate (%) |
|---|---|---|---|
| Radiation Conductor | 0 | 4 | 87.5 |
| Dummy Pattern | 1 | 4.26 | 87.5 |
| | 2 | 4.57 | 87.5 |
| | 3 | 4.92 | 87.5 |

Equation (1) is an example of a simplified structure to help understanding, for example, a structure in which the radiation conductor 135 or the dummy pattern 137 is formed in the shape of a single quadrangle, and as mentioned above, an equation (e.g., Equation (1)) for calculating an opened area rate may vary with a form of arrangement of conducting wires and a corresponding figure (e.g., a quadrangle).

For example, as shown in FIG. 2, as the conducting wires 133a are arranged in parallel with each other or are arranged to intersect each other, the mesh grid 133 may include arrangement of multiple quadrangles. The quadrangles of the mesh grid 133 may share parts of the conducting wires 133a and the discontinuous portion(s) 133b with their adjacent quadrangles. Thus, if a mesh grid of a manufactured antenna device has the shape illustrated in FIG. 2, a surface area of the conducting wires 133a and an area of the discontinuous portions 133b on the mesh grid 133 may be half of an opened area rate calculated using Equation (1). For example, the opened area rate of the mesh grid 133 shown in FIG. 2 may be defined as:

$$\text{Opened Area Rate} = \frac{(L1+W)(L2+W)\sin\theta - W(L1+L2+2W) + GWN/2}{(L1+W)(L2+W)\sin\theta} \cdots\cdots\cdots (2)$$

Since the surface area of the conducting wires 133a of a quadrangle located at an edge on the mesh grid 133 is not shared with another quadrangle, an opened area rate calculated using Equation (2) may be different from an opened area rate of a manufactured mesh grid. The accuracy of Equation (2) may be improved as the number of figures (e.g., quadrangles) formed by conducting wires in a mesh grid of a predetermined area increases and the line width W of the conducting wires decreases. It may also be easily understood that the accuracy of an opened area rate calculated using Equation (2) may be improved by reflecting the surface area of some conducting wires forming a quadrangle located at an edge on the mesh grid 133 into Equation (2).

In the radiation conductor 135 of the mesh grid 133 illustrated in FIG. 2, if the lengths L1 and L2 of a side of each quadrangle is set to 120 $\mu$m, the line width W of the conducting wires 133a is set to 4 $\mu$m, and the inclination $\theta$ between the conducting wires 133a is set to 90°, the opened area rate is calculated as 93.55%. In the dummy pattern 137 formed to have the same length and the same line width as the radiation pattern 135, if four discontinuous portions 133b, each having a length G of 30 $\mu$m, are disposed, the opened area rate of the dummy pattern 137 is calculated as 95.11%. For example, if conducting wires of a region where the radiation conductor 135 is formed and conducting wires of a region where the dummy pattern 137 is formed are formed to have the same length and the same line width, an opened area rate difference of about 1.6% occurs between the two regions, causing the Moire phenomenon based on a transmittance difference.

According to various embodiments of the present disclosure, the lengths L1 and L2 of conducting wires and the length G and number N of discontinuous portions are maintained equal to each other, and the width W of conducting wires of the region where the dummy pattern 137 is formed is adjusted to 5.33 $\mu$m, thus adjusting the opened area rate of the region where the dummy pattern 137 is formed to 93.53%. For example, the opened area rate of the region where the dummy pattern 137 is formed may be almost equal to an opened area rate of 93.55% of the region where the radiation conductor 135 is formed.

In the mesh grid 133 in the shape illustrated in FIG. 2, to form the dummy pattern 137 in which the lengths L1 and L2 of the conducting wires 133a are set to 120 $\mu$m, and the length G of each discontinuous portion 133b is set to 30 $\mu$m, the line width W of the conducting wires 133a and the number N of discontinuous portion(s) 133b may be set as shown in Table 2 to make a transmittance of the dummy pattern 137 almost equal to a transmittance of 93.55% of the radiation conductor 135.

[Table 2]

| Number (N) of Discontinuous Portion(s) | | Line Width (W) of Conducting Wires ($\mu$m) | Opened Area Rate (%) |
|---|---|---|---|
| Radiation Conductor | 0 | 4 | 93.55 |
| Dummy Pattern | 1 | 4.26 | 93.56 |
| | 2 | 4.57 | 93.55 |
| | 3 | 4.92 | 93.54 |

With reference to FIGS. 6 and 7, a structure in which the antenna device 103 is installed in an electronic device (e.g., the electronic device 100 of FIG. 1) will be described. When the antenna device 103 according to various embodiments of the present disclosure is installed in the electronic device (e.g., the electronic device 100 of FIG. 1), the antenna device 103 is installed on the display device 111 in FIGS. 6 and 7, but the present disclosure is not limited thereto. For example, the antenna device 103 according to various embodiments of the present disclosure may also be installed in an inner side of the main body portion 101 or inside the main body portion 101.

FIG. 6 is a cross-sectional view of a portion of an electronic device according to various embodiments of the present disclosure. FIG. 7 is a cross-sectional view of another example of an antenna device according to various embodiments of the present disclosure.

Referring to FIGS. 6 and 7, the antenna device 103 is disposed on the display device 111. For example, as shown in FIG. 6, the antenna device 103 may be interposed between the display device 111 and the window member 113. A touch screen panel 115 may be integrated into an inner side of the window member 113. For example, the dielectric substrate 131 may be disposed to confront the display device 111, and the touch screen panel 115 may be disposed to confront the display device 111, while having the antenna device 103 between the touch screen panel 115 and the display device 111. If the antenna device 103 is disposed between the window member 113 and the display device 111, the dielectric substrate 131 may include a transparent film formed of high-polymer synthetic resin. The antenna device 103 according to various embodiments of the present disclosure may pass the screen output from the display device 111 therethrough even when being installed on the display device 111, because the dielectric substrate 131 and a mesh grid (e.g., the conducting wires 133a) forming a radiation conductor are formed of transparent materials.

Referring to FIG. 7, the touch screen panel 115 may be integrated into the display device 111. The window member 113 may include the dielectric substrate 131 of the antenna device 103. The mesh grid (e.g., the conducting wires 133a) of the antenna device 103 may be formed in an inner side (or an outer side) of the dielectric substrate 131, for example, the window member 113. When the touch screen panel 115 is integrated into the display device 111, the antenna device 103 may be disposed to confront the display device 111, while having the touch screen panel 115 between the antenna device 103 and the display device 111.

As such, in the antenna device according to various embodiments of the present disclosure, a radiation conductor is formed in a transparent dielectric substrate using a mesh grid formed using a transparent conductor, installing the antenna device in a stacked manner with a display device. To electrically open the radiation conductor from another portion of the mesh grid, a discontinuous portion in which some of conducting wires of the mesh grid are removed may be formed, and by setting an opened area rate of a region where the discontinuous portion is formed to be similar or equal to that of a region where the radiation conductor is formed, a uniform light transmittance over the entire area of the antenna device may be obtained. Thus, even when the antenna device according to various embodiments of the present disclosure is installed to be stacked with the display device, display quality degradation caused by the Moire phenomenon may be prevented.

An electronic device according to various embodiments of the present disclosure includes a dielectric substrate, a mesh grid including conducting wires formed on at least one surfaces of the dielectric substrate, a radiation conductor including a first portion of the mesh grid, and a dummy pattern including a second portion of the mesh grid, in which the dummy pattern electrically opens the first portion forming the radiation conductor from another portion of the mesh grid other than the first portion, and conducting wires forming the radiation conductor are formed to have a line width that is different from a line width of conducting wires forming the dummy pattern.

The dielectric substrate includes a transparent film, and the conducting wires include a transparent conductor.

The transparent conductor includes at least one of graphene, nanowire, Indium-Tin Oxide (ITO), Indium-Zinc Oxide (IZO), Aluminum-Zinc Oxide (AZO), Ga-doped Zinc Oxide (GZO), Zinc-Tin Oxide (ZTO), Aluminum-Zinc-Tin Oxide (AZTO), Indium-Aluminum-Zinc-Tin Oxide (IAZTO), and Indium-Zinc-Tin Oxide (IZTO).

The conducting wires forming the dummy pattern include at least one discontinuous portions that are opened, such that the dummy pattern electrically opens the first portion forming the radiation conductor from the another portion of the mesh grid other than the first portion.

The line width of the conducting wires forming the dummy pattern is set to be proportional to a length and a number of the discontinuous portions.

A light transmittance of the second portion is adjusted according to a length and a number of the discontinuous portions and the line width of the conducting wires forming the dummy pattern. In other words, it is adjusted by varying the line width of the conducting wires of the second portion and a length and a number of the discontinuous portions.

The radiation conductor forms a portion of any one of a slot antenna, a loop antenna, a patch antenna, a monopole antenna, a dipole antenna, and a Yagi-Uda antenna.

The electronic device further includes a display device, in which the dielectric substrate is disposed on the display device.

The electronic device further includes a touch screen panel disposed on the display device, in which the touch screen panel is disposed to confront the display device, having the dielectric substrate between the touch screen panel and the display device.

The electronic device further includes a touch screen panel disposed on the display device, in which the dielectric substrate is disposed to confront the display device, having the touch screen panel between the dielectric substrate and the display device.

The dielectric substrate is formed of glass.

An antenna device according to various embodiments of the present disclosure includes a dielectric substrate formed of a transparent material, a mesh grid including transparent conducting wires formed on at least one surfaces of the dielectric substrate, a radiation conductor including a first portion of the mesh grid, and a dummy pattern including a second portion of the mesh grid, in which the dummy pattern includes at least one discontinuous portions in which portions of the conducting wires forming the dummy pattern are opened, to electrically open the first portion forming the radiation conductor from another portion of the mesh grid other than the first portion, and the conducting wires forming the radiation conductor are formed to have a line width that is different from a line width of the conducting wires forming the dummy pattern.

A light transmittance of the second portion is adjusted according to the line width of the conducting wires of the second portion and a length and a number of the discontinuous portions. In other words, it is adjusted by varying the line width of the conducting wires of the second portion and a length and a number of the discontinuous portions.

The antenna device further includes a transmission line connected to the radiation conductor to feed electricity to the radiation conductor.

The transmission line includes a Flexible Printed Circuit Board (FPCB) and a coaxial cable.

As is apparent from the foregoing description, in the antenna device, the dielectric substrate may be implemented in the form of a film, allowing the antenna device to be installed merely by being attached to a surface (e.g., an outer side of the display device or an inner side of the window member) of the electronic device. Thus, the antenna device may be easy to install in a small-size and light-weight electronic device. In addition, by forming the dummy pattern in which some conducting wires are used for the radiation conductor in the mesh grid including conducting wires formed of a transparent conductor and a portion of the radiation conductor is electrically opened from another portion, a uniform light transmittance may be secured over the entire area of the dielectric substrate. Thus, even if the antenna device is installed on the display device, superior display quality may be maintained, contributing to efficient use of a space of a small-size and light-weight electronic device.

Other effects that may be obtained or expected from the embodiments of the present disclosure are explicitly or implicitly disclosed in the detailed description of the embodiment of the present disclosure. For example, various effects expected from the embodiments of the present disclosure have been disclosed in the detailed description of the present disclosure.

The embodiments of the present disclosure provided in the present specification and the drawings merely provide particular examples to easily describe the technical contents of the present disclosure and to facilitate understanding of the present disclosure, rather than to limit the scope of the embodiments of the present disclosure. Thus, the scope of the embodiments of the present disclosure should be construed as including any changes or modifications derived from the embodiments of the present disclosure as well as the embodiments described herein.

**Claims**

1. An electronic device (100) comprising:

   a dielectric substrate (131) having a plurality of surfaces;
   a mesh grid (133) comprising conducting wires (133a) formed on at least one of the plurality of surfaces of the dielectric substrate (131);
   a first portion (A1) of the mesh grid (133) having a radiation conductor (135) formed by a first plurality of the conducting wires (133a); and
   a second portion (A2) of the mesh grid (133) having a dummy pattern formed by a second plurality of conducting wires (133a),
   wherein the second conducting wires comprise at least one discontinuous portions (133b) that are opened such that the dummy pattern (137) electrically opens the first portion (A1) forming the radiation conductor (135) from the mesh grid (133) less the first portion (A1),
   **characterized in that**,
   the line width (W) of the second conducting wires is larger than the line width of the first conducting wires such that a light transmittance of the first portion (A1) and a light transmittance of the second portion (A2) is substantially uniform.

2. The electronic device (100) of claim 1, wherein the dielectric substrate (131) comprises a transparent film, and the conducting wires (133a) comprise a transparent conductor.

3. The electronic device (100) of claim 2, wherein the transparent conductor comprises at least one of graphene, nanowire, Indium-Tin Oxide (ITO), Indium-Zinc Oxide (IZO), Aluminum-Zinc Oxide (AZO), Ga-doped Zinc Oxide (GZO), Zinc-Tin Oxide (ZTO), Aluminum-Zinc-Tin Oxide (AZTO), Indium-Aluminum-Zinc-Tin Oxide (IAZTO), and Indium-Zinc-Tin Oxide (IZTO).

4. The electronic device (100) of any one of the previous claims, wherein the radiation conductor (135) forms a portion of any one of a slot antenna, a loop antenna, a patch antenna, a monopole antenna, a dipole antenna, and a Yagi-Uda antenna.

5. The electronic device (100) of any one of the previous claims, further comprising a display device (111), wherein the dielectric substrate (131) is disposed on the display device (111).

6. The electronic device (100) of claim 5, further comprising a touch screen panel (115) disposed on the display device (111), wherein the touch screen panel (115) is disposed to confront the display device (111), having the dielectric substrate (131) between the touch screen panel (115) and the display device (111).

7. The electronic device (100) of claim 5, further comprising a touch screen panel (115) disposed on the display device (111), wherein the dielectric substrate (131) is disposed to face the display device (111), having the touch screen panel (115) between the dielectric substrate (131) and the display device (111).

8. The electronic device (100) of claim 7, wherein the dielectric substrate (131) is formed of glass.

9.  The electronic device (100) of claim 1, wherein the electronic device (100) is an antenna device (103).

10. The electronic device (100) any one of the previous claims, further comprising a transmission line (139) connected to the radiation conductor (135) to feed electricity to the radiation conductor (135).

11. The antenna device of claim 10, wherein the transmission line (139) comprises a Flexible Printed Circuit Board (FPCB) and a coaxial cable.


**Patentansprüche**

1.  Elektronische Vorrichtung (100), umfassend:

    ein dielektrisches Substrat (131), das eine Mehrzahl von Oberflächen aufweist;
    ein Netzgitter (133), umfassend Leitungsdrähte (133a), die an mindestens einer der Mehrzahl von Oberflächen des dielektrischen Substrates (131) ausgebildet sind;
    einen ersten Abschnitt (A1) des Netzgitters (133), der einen Strahlungsleiter (135) aufweist, der durch eine erste Mehrzahl der Leitungsdrähte (133a) ausgebildet ist; und
    einen ersten Abschnitt (A2) des Netzgitters (133), der ein Scheinmuster aufweist, das durch eine zweite Mehrzahl von Leitungsdrähten (133a) ausgebildet ist; und
    wobei die zweiten Leitungsdrähte mindestens einen diskontinuierlichen Abschnitt (133b) umfasst, der so geöffnet ist, dass das Scheinmuster (137) elektrisch den ersten Abschnitt (A1) öffnet, der den Strahlungsleiter (135) aus dem Netzgitter ausbildet (133) ohne den ersten Abschnitt (A1),
    **dadurch gekennzeichnet, dass**
    die Linienbreite (W) der zweiten Leitungsdrähte größer ist als die Linienbreite der ersten Leitungsdrähte, sodass eine Lichtübertragung des ersten Abschnittes (A1) und eine Lichtübertragung des zweiten Abschnittes (A2) im Wesentlichen gleichmäßig sind.

2.  Elektronische Vorrichtung (100) nach Anspruch 1, wobei das dielektrische Substrat (131) einen transparenten Film umfasst, und die Leitungsdrähte (133a) einen transparenten Leiter umfassen.

3.  Elektronische Vorrichtung (100) nach Anspruch 2, wobei der transparente Leiter mindestens eines aus Graphen, Nanodraht, Indium-Zinn-Oxid (ITO), Indium-Zink-Oxid (IZO), Aluminium-Zink-Oxid (AZO), Ga-dotiertes Zink-Oxid (GZO), Zink-Zinn-Oxid (ZTO), Aluminium-Zink-Zinn-Oxid (AZTO), Indium-Aluminium-Zink-Zinn-Oxid (IAZTO) und Indium-Zink-Zinn-Oxid (IZTO) umfasst.

4.  Elektronische Vorrichtung (100) nach einem der vorangehenden Ansprüche, wobei der Strahlungsleiter (135) einen Abschnitt bildet von einem aus einer Schlitzantenne, einer Rahmenantenne, einer Patchantenne, einer Monopolantenne, einer Dipolantenne und einer Yagi-Uda-Antenne.

5.  Elektronische Vorrichtung (100) nach einem der vorangehenden Ansprüche, ferner umfassend eine Anzeigevorrichtung (111), wobei das dielektrische Substrat (131) auf der Anzeigevorrichtung (111) angeordnet ist.

6.  Elektronische Vorrichtung (100) nach Anspruch 5, ferner umfassend einen berührungsempfindlichen Bildschirm (115), der auf der Anzeigevorrichtung (111) angeordnet ist, wobei der berührungsempfindliche Bildschirm (115) angeordnet ist, um der Anzeigevorrichtung (111) gegenüber zu liegen, wobei das dielektrische Substrat (131) zwischen dem berührungsempfindlichen Bildschirm (115) und der Anzeigevorrichtung (111) angeordnet ist.

7.  Elektronische Vorrichtung (100) nach Anspruch 5, ferner umfassend einen berührungsempfindlichen Bildschirm (115), der auf der Anzeigevorrichtung (111) angeordnet ist, wobei das dielektrische Substrat (131) angeordnet ist, um der Anzeigevorrichtung (111) gegenüber zu liegen, wobei der berührungsempfindliche Bildschirm (115) zwischen dem dielektrischen Substrat (131) und der Anzeigevorrichtung (111) angeordnet ist.

8.  Elektronische Vorrichtung (100) nach Anspruch 7, wobei das dielektrische Substrat (131) aus Glas gebildet ist.

9.  Elektronische Vorrichtung (100) nach Anspruch 1, wobei die elektrische Vorrichtung (100) eine Antennenvorrichtung (103) ist.

**10.** Elektronische Vorrichtung (100) nach einem der vorangehenden Ansprüche, ferner umfassend eine Übertragungsleitung (139), die mit dem Strahlungsleiter (135) verbunden ist, um den Strahlungsleiter (135) mit Strom zu versorgen.

**11.** Antennenvorrichtung nach Anspruch 10, wobei die Übertragungsleitung (139) eine flexible Leiterplatte (FPCB) und ein koaxiales Kabel umfasst.

**Revendications**

**1.** Dispositif électronique (100), comprenant :

un substrat diélectrique (131) présentant une pluralité de surfaces ;
un treillis métallique (133) comprenant des fils conducteurs (133a) présentés sur au moins une surface de la pluralité de surfaces du substrat diélectrique (131) ;
une première partie (A1) du treillis métallique (133) présentant un conducteur de rayonnement (135) formé par une première pluralité de fils conducteurs (133a) ; et
une deuxième partie (A2) du treillis métallique (133) présentant un motif factice formé par une deuxième pluralité de fils conducteurs (133a),
où les deuxièmes fils conducteurs comprennent une ou plusieurs parties discontinues (133b) ouvertes de telle manière que le motif factice (137) ouvre électriquement la première partie (A1) formant le conducteur de rayonnement (135) dans le treillis métallique (133) moins la première partie (A1),
**caractérisé en ce que**
la largeur de ligne (W) des deuxièmes fils conducteurs est supérieure à la largeur de ligne des premiers fils conducteurs, de sorte que la transmittance lumineuse de la première partie (A1) et la transmittance lumineuse de la deuxième partie (A2) sont sensiblement uniformes.

**2.** Dispositif électronique (100) selon la revendication 1, où le substrat diélectrique (131) comprend un film transparent, et où les fils conducteurs (133a) comprennent un conducteur transparent.

**3.** Dispositif électronique (100) selon la revendication 2, où le conducteur transparent comprend au moins un des éléments suivants : graphène, nanofil, oxyde d'indium-étain (ITO), oxyde d'indium-zinc (IZO), oxyde d'aluminium-zinc (AZO), oxyde de zinc dopé au gallium (GZO), oxyde de zinc-étain (ZTO), oxyde de zinc-étain-aluminium (AZTO), oxyde d'indium-aluminium-zinc-étain (IAZTO), et oxyde d'indium-zinc-étain (IZTO).

**4.** Dispositif électronique (100) selon l'une des revendications précédentes, où le conducteur de rayonnement (135) est une partie d'une des antennes suivantes: antenne à fente, antenne cadre, antenne à plaque, antenne unipolaire, antenne dipôle et antenne Yagi-Uda.

**5.** Dispositif électronique (100) selon l'une des revendications précédentes, comprenant en outre un dispositif d'affichage (111), le substrat diélectrique (131) étant disposé sur le dispositif d'affichage (111).

**6.** Dispositif électronique (100) selon la revendication 5, comprenant en outre un panneau d'écran tactile (115) disposé sur le dispositif d'affichage (111), ledit panneau d'écran tactile (115) étant disposé de manière à faire face au dispositif d'affichage (111), le substrat diélectrique (131) étant intercalé entre le panneau d'écran tactile (115) et le dispositif d'affichage (111).

**7.** Dispositif électronique (100) selon la revendication 5, comprenant en outre un panneau d'écran tactile (115) disposé sur le dispositif d'affichage (111), le substrat diélectrique (131) étant disposé de manière à faire face au dispositif d'affichage (111), le panneau d'écran tactile (115) étant intercalé entre le substrat diélectrique (131) et le dispositif d'affichage (111).

**8.** Dispositif électronique (100) selon la revendication 7, où le substrat diélectrique (131) est en verre.

**9.** Dispositif électronique (100) selon la revendication 1, où ledit dispositif électronique (100) est un dispositif d'antenne (103).

**10.** Dispositif électronique (100) selon l'une des revendications précédentes, comprenant en outre une ligne de transmission (139) reliée au conducteur de rayonnement (135) pour transporter de l'électricité vers le conducteur de rayonnement (135).

11. Dispositif d'antenne selon la revendication 10, où la ligne de transmission (139) comprend une carte de circuit imprimé flexible (FPCB) et un câble coaxial.

EP 3 041 086 B1

FIG.1

14

# FIG.2

# FIG.3

FIG.4

FIG.5

FIG.6

FIG.7

**EP 3 041 086 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0911906 A2
- EP 1868263 A1